# EUROPÄISCHE PATENTSCHRIFT

(11) **EP 2 220 652 B1**
(45) Veröffentlichungstag und Bekanntmachung des Hinweises auf die Patenterteilung: **04.03.2015**
(21) Anmeldenummer: 08773737.5
(22) Anmeldetag: 27.06.2008
(51) Int. Cl.: G11C 16/10

(54) **VERFHAREN ZUM SPEICHERN EINES DATUMS IN EINER SPEICHEREINRICHTUNG UND SPEICHEREINRICHTUNG**
METHOD FOR STORING DATE IN MEMORY DEVICE AND MEMORY DEVICE
PROCÉDÉ DE MÉMORISATION D'UNE DATE DANS UN DISPOSITIF DE MÉMORISATION ET DISPOSITIF DE MÉMORISATION

(30) Priorität: 07.12.2007 DE 102007059142
(43) Veröffentlichungstag der Anmeldung: 25.08.2010
(73) Patentinhaber: Giesecke & Devrient GmbH, 81677 München (DE)
(72) Erfinder: STOCKER, Thomas, 81739 München (DE); BALDISCHWEILER, Michael, 81825 München (DE)
(86) Internationale Anmeldenummer: PCT/EP2008/005282
(87) Internationale Veröffentlichungsnummer: WO 2009/071134

(56) Entgegenhaltungen:
- EP-A- 1 215 679
- WO-A-97/12367
- DE-B3- 10 336 225
- US-A1- 2007 061 504

## Beschreibung

Die Erfindung betrifft ein Verfahren zum Speichern eines Datums mit einer Anzahl an Bits in einer Speichereinrichtung eines Datenträgers, insbesondere eines tragbaren Datenträgers, sowie eine Speichereinrichtung. Die Speichereinrichtung weist einen Speicher mit zumindest einem ersten und einem zweiten Datenelement auf, welche jeweils eine Anzahl von binären Speicherzellen umfassen, die der Anzahl der Bits des Datums entspricht, wobei jede Speicherzelle durch einen Programmiervorgang zwischen einem gelöschten und einem beschriebenen Zustand schaltbar ist. Der Speicher ist bezüglich Schreibvorgängen, bei denen der beschriebene Zustand herstellbar ist, und Löschvorgängen, bei denen der gelöschte Zustand herstellbar ist, asymmetrisch.

Ein elektronischer Speicher ist in der Regel in eine Mehrzahl an Speicherzellen unterteilt. Beim Programmieren des Speichers, d.h. beim Schreiben oder Löschen von Speicherinhalten, werden die einzelnen Speicherzellen von einem ersten Speicherzustand, beispielsweise einer logischen "1", in einen zweiten Speicherzustand, beispielsweise eine logische "0", gebracht und umgekehrt, wozu Löschvorgänge und Schreibvorgänge durchgeführt werden. Welcher Zustand von dem gelöschten und dem beschriebenen Speicherzustand dabei eine logische "1" und welcher eine logische "0" ist, ist in der Regel frei wählbar und wird in der Regel durch den Hersteller des Speichers festgelegt.

Eine Mehrzahl von elektronischen Speichern, z.B. EEPROM oder Flash-ROM (Flash-EEPROM) sind bezüglich des Schreibens und des Löschens von Daten asymmetrisch, indem beispielsweise die Zeitdauer, die zum Löschen des Speichers erforderlich ist, (Löschzeit oder Löschdauer) unterschiedlich ist von der Zeitdauer, die zum Beschreiben des Speichers erforderlich ist (Schreibzeit oder Schreibdauer).

Bei einem bekannten Flash-EEPROM-Speicher ist für eine einzelne Speicherzelle logisch "1" der gelöschte Zustand und logisch "0" der beschriebene Zustand. Bei diesem Flash-EEPROM-Speicher dauert das Schreiben, bei dem einzelne Speicherzellen von logisch "1" auf logisch "0" umprogrammiert werden, ungefähr 100 µs, wohingegen das Löschen von Speicherzellen, das bei dem Flash-EEPROM-Speicher (Flash-Speicher) in der Regel in Einheiten von Speicherseiten (sog. Pages) oder Blocks durchgeführt wird und bei dem die Speicherzellen von logisch "0" auf logisch "1" umprogrammiert werden, ungefähr 4 ms. Vor dem Löschen der Speicherzellen müssen daher alle in dem Speicher enthaltenen Daten zwischengespeichert werden und nach dem Löschen neu einprogrammiert werden. Nachteil hierbei ist, dass Löschvorgänge damit einen im Vergleich zu Schreibvorgängen langen Zeitbedarf aufweisen.

Aus der EP 1 517 333 A1 ist es bekannt, in einem Flash-Speicher, der sich bezüglich Schreiben und Löschen asymmetrisch verhält, ein die Zustände "gültig" und "nicht gültig" einnehmendes Zustandskennzeichen (Flag) zu realisieren, das durch dieselbe Art von Speicherzugriff, also "Schreiben" oder "Löschen" zwischen den Zuständen "gültig" und "nicht gültig" hin- und herschaltbar ist. Erreicht wird dies durch eine in Softwareform und/ oder in Hardwareform implementierte XOR-Verknüpfung zweier Speicherzellen, wobei das Ergebnis der Verknüpfung als Zustandswert des Zustandskennzeichens ausgegeben oder für eine weitere Berechnung des Zustandswerts bereitgestellt wird.

Es ist daher Aufgabe der vorliegenden Erfindung, ein Verfahren zum Speichern eines Datums in einer Speichereinrichtung sowie eine Speichereinrichtung der eingangs genannten Art anzugeben, welche die Verkürzung von Schreibzugriffszeiten auf die Speichereinrichtung ermöglichen.

Diese Aufgabe wird gelöst durch ein Verfahren gemäß dem unabhängigen Patentanspruch 1 sowie eine Speichereinrichtung gemäß dem unabhängigen Patentanspruch 10. Vorteilhafte Ausgestaltungen der Erfindung sind jeweils in den abhängigen Patentansprüchen angegeben.

Bei einem erfindungsgemäßen Verfahren zum Speichern eines Datums mit einer Anzahl an Bits in einer Speichereinrichtung eines Datenträgers, insbesondere einem tragbaren Datenträger (wie z.B. einer Chipkarte), weist die Speichereinrichtung einen Speicher mit zumindest einem ersten und einem zweiten Datenelement auf, welche jeweils eine Anzahl von binären Speicherzellen umfassen, die der Anzahl der Bits des Datums entspricht. Jede Speicherzelle ist durch einen Programmiervorgang zwischen einem gelöschten und einem beschriebenen Zustand schaltbar. Der Speicher ist bezüglich Schreibvorgängen, bei denen der beschriebene Zustand hergestellt wird, und Löschvorgängen, bei denen der gelöschte Zustand hergestellt wird, asymmetrisch. Es wird durch eine Logikeinheit der Speichereinrichtung überprüft, ob das zu speichernde Datum sich aus einer Modifikation jeweiliger Speicherzellen des ersten und/ oder des zweiten Datenelements, die logisch miteinander verknüpft sind, unter der Bedingungen erzeugen lässt, dass jede zur Erzeugung des Datums zu modifizierendes Speicherzelle des ersten und/ oder des zweiten Datenelements ausschließlich durch die gleiche Art von Programmiervorgang durchgeführt werden kann, und wenn die Bedingung erfüllt ist, das Datum durch den Programmiervorgang der jeweiligen Speicherzellen des ersten und/oder zweiten Datenelements erzeugt wird.

Für das Speichern des Datums wird damit die doppelte Menge an Speicherzellen benötigt, wie das Datum aufweist. Die Anzahl der Speicherzellen ist auf ein erstes und ein zweites Datenelement verteilt, welche logisch miteinander verknüpft sind. Aus der logischen Verknüpfung des ersten und des zweiten Datenelements ergibt sich der Inhalt eines gespeicherten Datums. Durch die logische Verknüpfung zweier Datenelemente kann im Vergleich zu einem Speichern des Datums in einem einzigen Datenelement in vielen Fällen auf einen langsamen Programmiervorgang verzichtet werden. Ein langsamer Programmiervorgang liegt beispielsweise bei einem fälligen Löschen von Speicherzellen vor, weil wenigstens ein Bitübergang von logisch "0" auf logisch "1" erforderlich ist. Durch die logische Verknüpfung zweier Datenelemente kann ein solches Löschen vermieden werden. Das Einspeichern eines Datums in eine Speichereinrichtung ist hierdurch effizienter als bei bekannten Speichereinrichtungen durchführbar. Hierdurch kann die Lebensdauer der Speichereinrichtung, insbesondere eines Flash-EEPROM-Speichers, verbessert werden. Zum anderen lassen sich Zugriffszeiten zum Speichern eines Datums verkürzen.

Die Asymmetrie bezüglich Schreibvorgängen und Löschvorgängen umfasst, dass ein Schreibvorgang eine kürzere Programmierdauer hat als ein Löschvorgang, oder umgekehrt, und der Programmiervorgang verwendet wird, der die kürzere Programmierdauer hat. Diese Ausführungsform hat den Vorteil, dass das Speichern des Datums solche Programmiervorgänge verwendet, welche schnell durchzuführen sind. Hierdurch ist das Datum besonders zeitsparend und effizient zu speichern.

Das erfindungsgemäße Verfahren sieht weiter vor, zumindest das erste und/oder das zweite Datenelement zu löschen (d.h. einen Löschvorgang durchzuführen), wenn sich das zu speichernde Datum nicht durch einen Schreibvorgang jeweiliger Speicherzellen des ersten und/ oder des zweiten Datenelements erzeugen lässt. Gemäß dieser Ausführungsvariante wird sichergestellt, dass das zu speichernde Datum auch dann in der Speichereinrichtung abgelegt werden kann, wenn sich dieses nicht aus der logischen Verknüpfung des ersten und/ oder des zweiten Datenelements unter der Bedingung erzeugen lässt, dass jede zur Erzeugung des Datums zu modifizierende Speicherzelle des ersten und/ oder des zweiten Datenelements ausschließlich durch die gleiche Art von Programmiervorgang durchgeführt werden kann.

Die logische Verknüpfung des ersten und des zweiten Datenelements ist durch eine Exklusiv-NICHT-ODER-Verknüpfung (XNOR) gebildet.

Es ist zweckmäßig, wenn das erste und das mit dem ersten Datenelement logisch verknüpfte zweite Datenelement in dem Datenspeicher hintereinander angeordnet werden bzw. sind. Hierdurch lässt sich die Verknüpfung auf besonders einfache Weise implementieren. Das erste und das zweite Datenelement können beispielsweise als Bytes des Speichers ausgebildet sein. Gemäß einer anderen Ausgestaltung sind das erste und das zweite Datenelement Speicherseiten (Pages) des Speichers, welche logisch miteinander verknüpft werden.

Da das erfindungsgemäße Verfahren im Vergleich zu bekannten Speichereinrichtungen zur Speicherung der gleichen Datenmenge eine Verdoppelung des Speichers benötigt, ist gemäß einer zweckmäßigen Ausgestaltung der Erfindung vorgesehen, dass die Speichereinrichtung einen weiteren Speicher mit weiteren Datenelementen aufweist, welche keine Zuordnung zu anderen Datenelementen aufweisen, wobei erste Informationen und/ oder Variablen in dem ersten und dem mit dem ersten logisch verknüpften zweiten Datenelement und zweite Informationen und/ oder Variablen in den weiteren Datenelementen des weiteren Speichers gespeichert werden. Gemäß dieser Ausgestaltung ist vorgesehen, lediglich ausgewählte Informationen in dem Speicher mit den verknüpften Datenelementen vorzusehen. Diese können beispielsweise Informationen und/oder Variablen sein, welche in regelmäßigen Abständen einer Änderung unterliegen. Bei diesen kommt der schnellere Schreibzugriff des Verfahrens besonders zum Tragen.

Die Auswahl, welche ersten Informationen und/oder Variablen in dem ersten und dem mit dem ersten logisch verknüpften zweiten Datenelement gespeichert und/oder aus diesem ausgelesen werden sollen, werden gemäß einer Ausführung einem Compiler über ein Schlüsselwort mitgeteilt. Dieses Schlüsselwort kann beispielsweise der Information und/ oder Variablen vorangestellt sein. Bei Erkennung des Schlüsselworts durch den Compiler ist damit sichergestellt, dass die betreffende Information nicht in dem weiteren Speicher, sondern in dem Speicher mit den verknüpften Datenelementen abgelegt ist.

Es ist ferner vorgesehen, dass ein Interrupt erzeugt wird, wenn sich das zu speichernde Datum nicht durch einen Schreibvorgang jeweiliger Speicherzellen des ersten und/ oder des zweiten Datenelements erzeugen lässt.

Eine erfindungsgemäße Speichereinrichtung eines Datenträgers, insbesondere eines tragbaren Datenträgers, weist einen elektronischen Speicher mit zumindest einem ersten und einem zweiten Datenelement auf, welche jeweils eine Mehrzahl von binären Speicherzellen umfassen, wobei jede Speicherzelle durch einen Programmiervorgang zwischen einem gelöschten und einem beschriebenen Zustand schaltbar ist. Der Speicher ist bezüglich Schreibvorgängen, bei denen der beschriebene Zustand herstellbar ist, und Löschvorgängen, bei denen der gelöschte Zustand herstellbar ist, asymmetrisch. Eine Logikeinheit ist dazu ausgebildet, zum Überprüfen, ob das zu speichernde Datum sich aus einer Modifikation jeweiliger Speicherzellen des ersten und/oder des zweiten Datenelements, die über eine logische Verknüpfung einander zugeordnet sind, unter der Bedingung erzeugen lässt, das jede zur Erzeugung des Datums zu modifizierende Speicherzelle des ersten und/ oder des zweiten Datenelements ausschließlich durch die gleiche Art von Programmiervorgang durchgeführt werden kann, und, wenn die Bedingung erfüllt ist, zum Erzeugen des Datums durch den Programmiervorgang der jeweiligen Speicherzellen des ersten und/oder zweiten Datenelements. Die erfindungsgemäße Speichereinrichtung weist die gleichen Vorteile auf, wie sie vorstehend in Verbindung bei der Beschreibung des erfindungsgemäßen Verfahrens erläutert wurden.

Das erste und das zweite Datenelement repräsentieren in einer ersten Variante ein Byte des Speichers. Das erste und das zweite Datenelement können auch eine Speicherseite des Speichers repräsentieren. Der Speicher ist in einer zweckmäßigen Ausgestaltung ein Flash-EEPROM-Speicher (Flash-Speicher) zum Speichern von Daten und/oder Programmen.

Die Erfindung wird nachfolgend weiter anhand der Zeichnungen erläutert. Es zeigen:
- Fig.1: eine Darstellung mit möglichen Bit-Zuständen eines Datenelements im zeitlichen Ablauf,
- Fig. 2a, 2b: jeweils zwei über eine XNOR-Verknüpfung logisch miteinander verknüpfte Datenelemente,
- Fig. 3: eine Darstellung eines möglichen Ablaufs zweier über eine XNOR-Verknüpfung logisch miteinander verknüpfter Datenelemente,
- Fig. 4a, 4b: ein Ausführungsbeispiel des erfindungsgemäßen Verfahrens beim Speichern eines Datenelements, und
- Fig. 5: eine schematische Darstellung einer erfindungsgemäßen Speichereinrichtung.

Die Erfindung wird nachfolgend anhand eines Flash-Speichers beschrieben, bei dem die Speicherzellen nach dem Löschen in einem Grundzustand jeweils auf Hexadezimal "F", d.h. auf 1111 stehen. Aufgrund der Asymmetrie des Flash-Speichers bei Löschvorgängen, bei denen einzelne Speicherzellen von logisch "0" auf logisch "1" übergehen, und Schreibvorgängen, bei denen jeweiligen Speicherzellen von logisch "1" auf logisch "0" übergehen, ist ein schnelles Schreiben in eine solche Speicherzelle so lange möglich, wie einzelne Bits von logisch "1" auf logisch "0" umgeworfen werden können. Ist ein Übergang von logisch "0" auf logisch "1" bei einer Speicherzelle erforderlich, so muss die gesamte Speicherzelle bzw. eine Speicherseite bzw. der gesamte Speicher zunächst zeitaufwändig und zellenbelastend gelöscht werden. Um eine Verkürzung von Schreibzugriffszeiten auf den Speicher und darüber hinaus eine Verbesserung der Lebensdauer des Speichers zu erzielen ist nun vorgesehen, ein fälliges Löschen von Speicherzellen, weil wenigstens ein Bitübergang von logisch "0" auf logisch "1" erforderlich ist, zu ersetzen durch eine logische Verknüpfung zweier Datenelemente. Als logische Verknüpfung wird eine XNOR-Verknüpfung vorgesehen.

Bei einer NAND-Speicherseite sind bei einem gegebenen Ausgangswert 0x0F fünf Zustände möglich, ohne dass ein Löschvorgang durchgeführt werden müsste:
- 1111:: Das Datenelement kann 2⁴ verschiedene Zustände annehmen.
- 0111:: Das Datenelement kann 2³ unterschiedliche Zustände annehmen.
- 0011:: Das Datenelement kann 2² unterschiedliche Zustände annehmen.
- 0001:: Das Datenelement kann 2¹ unterschiedliche Zustände annehmen.
- 0000:: Das Datenelement kann keine weiteren abweichenden Zustände mehr annehmen.

Bei dem erfindungsgemäßen Verfahren sind damit in einem Datenelement, das vier Speicherzellen aufweist, 2⁴/2 verschiedene Zustände bzw. Werte darstellbar. Allgemein sind 2ⁿ/2 verschiedene Werte darstellbar, wobei n die Anzahl der Speicherzellen eines Datenelements angibt. Gemäß dem obigen Ausführungsbeispiel kann das Datenelement damit 8 unterschiedliche Werte annehmen.

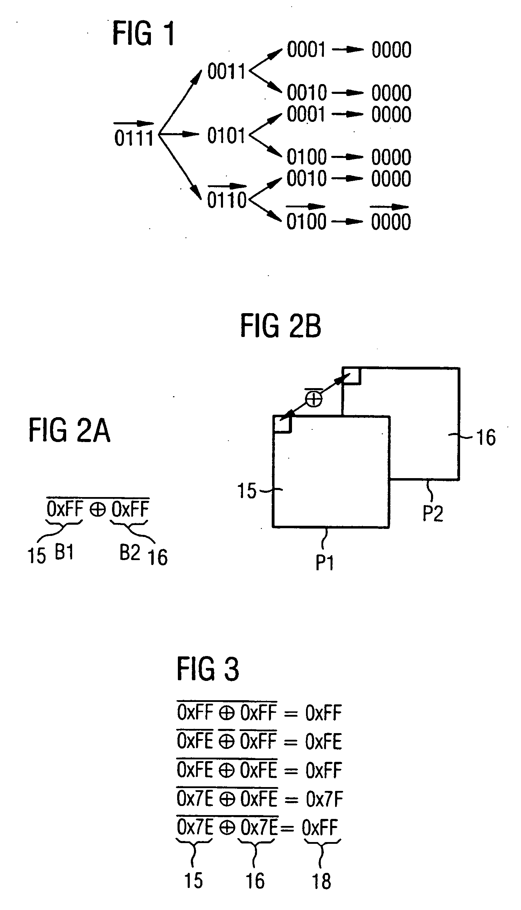

Fig.1 zeigt eine Darstellung eines Datenelement, das den Wert 0x07 (0111) als Ausgangszustand aufweist. Ausgehend von diesem Ausgangszustand kann das Datenelement noch maximal vier Werte annehmen, bevor es gelöscht werden muss. Bei diesem Löschvorgang wird, wie eingangs beschrieben, jede Speicherzelle des Datenelements auf den Grundzustand logisch "1" gesetzt. Ausgehend von dem Ausgangswert 0x07 kann das Datenelement bei einem ersten Übergang die Werte 0x03 (0011), 0x05 (0101)und 0x06 (0110) annehmen. Ausgehend von dem Wert 0x03 kann das Datenelement weiterhin noch die Werte 0x01 (0001) und 0x02 (0010) annehmen. Ausgehend von dem Wert 0x05 (0101) kann das Datenelement im weiteren zeitlichen Verlauf die Werte 0x01 (0001) und 0x04 (0100) annehmen. Ausgehend von dem Wert 0x06 (0110) kann das Datenelement die Werte 0x02 (0002) und 0x04 (0110) annehmen. Hernach ist im weiteren Verlauf bei allen Varianten noch ein Übergang auf den Wert 0x00 (0000) möglich.

Um nicht bei jedem Bitwechsel einer Speicherzelle von logisch "0" auf logisch "1" eine Speicherseite oder den Speicher wieder neu beschreiben zu müssen, wird vorgeschlagen, zwei Datenelemente 15 und 16, z.B. zwei Bytes B1 und B2 (vgl. Fig. 2a) oder zwei Speicherseiten P1 und P2 (vgl. Fig. 2b) über eine XNOR-Verknüpfung miteinander zu verknüpfen. Sind die Datenelemente 15,16 als Bytes ausgebildet, so erfolgt die XNOR-Verknüpfung zweckmäßigerweise für zwei aufeinander folgende Bytes. Die XNOR-Verknüpfung kann durch Software in einer Logikeinheit implementiert sein. Die Verknüpfung kann auch über einen Hardwaremechanismus erfolgen.

Fig. 3 zeigt den zeitlichen Ablauf des sich aus der Verknüpfung der zwei Datenelemente 15,16 ergebenden Datums 18 von oben nach unten. Zunächst enthalten das erste und das zweite Datenelement 15,16 jeweils den Wert 0xFF. Hieraus ergibt sich aus der XNOR-Verknüpfung das Datum 0xFF. Durch einen Schreibvorgang, bei dem die Speicherzelle des geringstwertigen Bits von logisch "1" auf logisch "0" gesetzt wird, enthält das erste Datenelement 15 nunmehr den Wert 0xFE. Aus der Verknüpfung der Werte 0xFE und 0xFF des ersten und des zweiten Datenelements 15,16 ergibt sich das Datum OxFE. Wird in einem nächsten Schritt auch das geringstwertige Bit des zweiten Datenelements 16 von logisch "1" auf logisch "0" gesetzt, so enthält auch das zweite Datenelement 16 den Wert 0xFE. Aus der XNOR-Verknüpfung des ersten und zweiten Datenelements 15,16 ergibt sich das Datum 0xFF. Wird in einem nächsten Schritt der Wert des ersten Datenelements 15 von OxFE auf 0x7E geändert, was sich ebenfalls durch ausschließliche Schreibvorgänge jeweiliger Speicherzellen des ersten Datenelements 15 realisieren lässt, so ergibt sich aus der logischen XNOR-Verknüpfung mit dem Wert OxFE des zweiten Datenelements 16 das Datum 0x7F. Wird schließlich auch der Wert des zweiten Datenelements 16 von OxFE auf Ox7E geändert, so ergibt sich aus der logischen Verknüpfung von 0x7E des ersten Datenelements 15 und Ox7E des zweiten Datenelements 16 das Datum 0xFF. Dieses Ausführungsbeispiel verdeutlicht das der Erfindung zu Grunde liegende Prinzip, bei dem sich ein in dem Speicher einzuspeicherndes Datum aus der logischen XNOR-Verknüpfung zweier Datenelemente 15,16 ergibt. Hierbei kann sich ein bestimmtes Datum aus der Verknüpfung unterschiedlicher Werte der Datenelemente 15,16 ergeben.

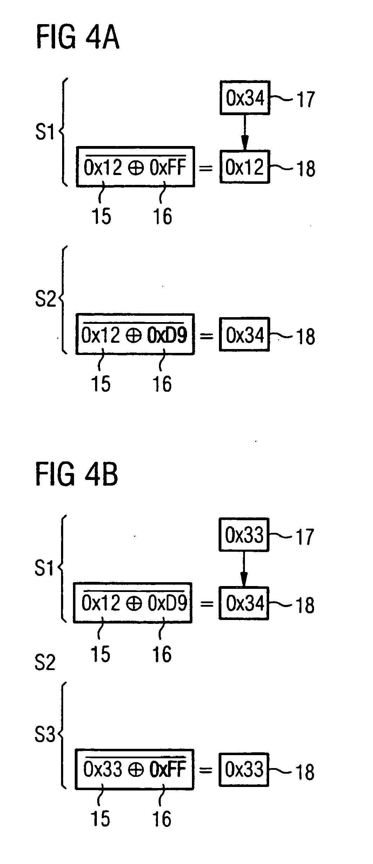

Anhand der Fig. 4a, 4b wird das der Erfindung zu Grunde liegende Verfahren weiter verdeutlicht. Es wird davon ausgegangen, dass ein Datum 17 (0x34) gespeichert werden soll. Hierzu werden in einem Schritt S1 zunächst die Werte des ersten und zweiten Datenelements 15,16 und das sich aus der logischen XNOR-Verknüpfung ergebende Datum 18 ausgelesen. Der Wert des ersten Datenelements 15 beträgt im Ausführungsbeispiel 0x12. Der Wert des zweiten Datenelements 16 ist 0xFF. Aus der logischen XNOR-Verknüpfung ergibt sich 0x12 als Datum 18. Es wird nun überprüft, ob sich ausschließlich durch einen oder mehrere Schreibvorgänge jeweiliger Speicherzellen des ersten und/ oder des zweiten Datenelements 15,16 eine Kombination ergibt, welche bei einer logischen XNOR-Verknüpfung zu dem zu speichernden Datum 0x34 führt. Hierzu kann zunächst überprüft werden, ob sich durch entsprechende Schreibvorgänge jeweiliger Speicherzellen des ersten Datenelements 15 ein Wert ergibt, der in Verknüpfung mit dem Wert des zweiten Datenelements 16 zu dem gewünschten Datum führt. Ist dies nicht der Fall, so wird überprüft, ob durch Schreibvorgänge jeweiliger Speicherzellen des zweiten Datenelements 16 ein Wert erzeugbar ist, der in Verknüpfung mit dem gegebenen Wert des ersten Datenelements 15 zu dem gewünschten Datum führt. Im Ausführungsbeispiel lässt sich das zu speichernde Datum 0x34 durch Schreibvorgänge einiger der Speicherzellen des zweiten Datenelements 16 erzeugen. Hierbei wird der ursprüngliche Wert 0xFF auf 0xD9 verändert, wodurch in Verknüpfung mit dem Wert 0x12 sich der gewünschte Wert 0x34 ergibt.

Soll nun (vgl. Fig. 4b) das Datum 0x33 geschrieben werden, so werden zunächst wieder der Inhalt der Datenelemente 15,16 und die sich daraus ergebende Verknüpfung überprüft. Die Datenelemente 15,16 weisen in diesem Ausführungsbeispiel die vorher (Fig. 4a) geschriebenen Werte 0x12 und 0xD9 auf. Nach einer Überprüfung ergibt sich, dass weder der Wert des Datenelements 15 noch der Wert des zweiten Datenelements 16 derart verändert werden kann, dass sämtliche zu ändernde Speicherzellen jeweils durch einen Schreibvorgang zu dem gewünschten Datum verändert werden könnten. In diesem Fall kann beispielsweise ein Interrupt ausgelöst werden, aufgrund dessen in Schritt S2 ein Löschen der Werte der Datenelemente 15,16 bzw. der gesamten Speicherseite vorgenommen wird. Beim Löschen der Datenelemente bzw. der Speicherseite werden diese in einen Grundzustand versetzt, so dass die Datenelemente zunächst als Wert jeweils 0xFF aufweisen. In Schritt S3 kann dann wahlweise in das erste oder zweite Datenelement 15,16 der gewünschte zu schreibende Wert 0x33 eingeschrieben werden, so dass sich aus der Verknüpfung mit 0xFF das gewünschte Datum 0x33 ergibt.

Gleichzeitig kann bei einem erzeugten Interrupt überprüft werden, ob eine Bitkombination 0 XNOR 0 vorhanden ist. Ist dies der Fall, werden diese Bits gelöscht, da 0 XNOR 0 dem Zustand 1 XNOR 1 entspricht. Die Erzeugung eines Interrupts ist dann zweckmäßig, wenn für das Schreiben bzw. Auslesen des XNOR-Wertes Hardwarekomponenten verwendet werden.

Da jeweils nur die Hälfte des Speichers aktiv nutzbar ist bzw. ein doppelt so großer Speicher bereitgestellt werden muss, ist es zweckmäßig, wenn nur ausgewählte Informationen und/ oder Variablen auf die beschriebene Weise gehandhabt werden. Die Auswahl kann beispielsweise einem Compiler über ein Schlüsselwort mitgeteilt werden, wobei das Schlüsselwort der zu schreibenden/lesenden Information und/ oder Variablen vorangestellt werden kann. Das Verfahren bietet sich insbesondere zum Speichern solcher Informationen an, die in regelmäßigen Abständen einer Änderung unterliegen. Vorteil der beschriebenen Vorgehensweise ist die deutliche Verringerung von Löschvorgängen und die verbesserte Zugriffszeit.

Prinzipiell sind mehrere Schreibvorgänge auf ein Datenelement möglich (mindestens zwei im schlechtesten Fall) bis ein Löschvorgang erfolgen muss.

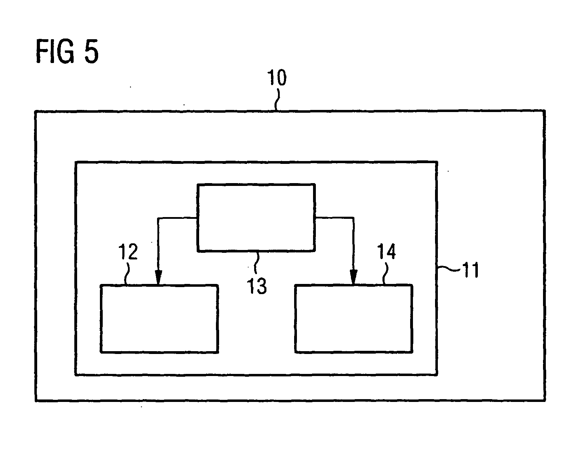

Fig. 5 zeigt in einer schematischen Darstellung eine erfindungsgemäße Speichereinrichtung 11, welche auf einem tragbaren Datenträger, z.B. einer Chipkarte, verwirklicht sein kann. Die Speichereinrichtung 11 umfasst einen Speicher 12 sowie einen weiteren Speicher 14, deren Inhalte jeweils über eine Logikeinheit 13 festgelegt werden können. Der Speicher 12 umfasst hierbei Datenelemente, welche jeweils paarweise über eine logische XNOR-Verknüpfung miteinander verbunden sind. Ebenso können, wie dies bereits erläutert wurde, Speicherseiten logisch über XNOR verknüpft sein. Der weitere Speicher 14 bildet einen herkömmlichen Speicher ab, bei dem Datenelemente keinerlei Verknüpfung der beschriebenen Art aufweisen.

Das vorbeschriebene Prinzip, das Löschen von Speicherzellen hinauszuschieben, indem stattdessen zusätzliche Speicherzellen beschrieben und mit den eigentlich zu löschenden Speicherzellen logisch verknüpft werden, lässt sich bei entsprechenden Speicherressourcen durch selbstähnliche Wiederholung grundsätzlich beliebig weiterführen. Durch logische Verknüpfung mit immer weiteren hierzu bereitgestellten vierten, fünften, sechsten u.s.w. Datenelementen kann die Zeit, bis ein Löschen unvermeidlich wird, entsprechend weiter hinausgeschoben werden, allerdings auf Kosten eines jeweils erhöhten Speicherverbrauchs.

## Patentansprüche

1. Verfahren zum Speichern eines Datums (17) mit einer Anzahl an Bits in einer Speichereinrichtung (11) eines Datenträgers (10), insbesondere eines tragbaren Datenträgers (10), wobei die Speichereinrichtung (11) einen Speicher (12) mit zumindest einem ersten und einem zweiten Datenelement (15,16) aufweist, welche jeweils eine Anzahl von binären Speicherzellen umfassen, die der Anzahl der Bits des Datums (17) entspricht, wobei jede durch einen Programmiervorgang zwischen einem gelöschten und einem beschriebenen Zustand schaltbar ist und wobei der Speicher (12) bezüglich Schreibvorgängen, bei dem der beschriebene Zustand hergestellt wird, und Löschvorgängen, bei dem der gelöschte Zustand hergestellt wird, asymmetrisch ist, bei dem
- durch eine Logikeinheit (13) der Speichereinrichtung (11) überprüft wird, ob das zu speichernde Datum sich aus einer Modifikation jeweiliger Speicherzellen des ersten und/ oder des zweiten Datenelements (15,16), die logisch miteinander verknüpft sind, unter der Bedingung erzeugen lässt, dass jede zur Erzeugung des Datums (17) zu modifizierende des ersten und/oder des zweiten Datenelements (15,16) ausschließlich durch die gleiche Art von Programmiervorgang durchgeführt werden kann, und
- wenn die Bedingung erfüllt ist, das Datum durch den Programmiervorgang der jeweiligen Speicherzellen des ersten und/ oder zweiten Datenelements (15,16) erzeugt wird.

2. Verfahren nach Anspruch 1, bei dem die Asymmetrie bezüglich Schreibvorgängen und Löschvorgängen umfasst, dass ein Schreibvorgang eine kürzere Programmierdauer hat als ein Löschvorgang, oder umgekehrt, und der Programmiervorgang verwendet wird, der die kürzere Programmierdauer hat.

3. Verfahren nach Anspruch 2, bei dem zumindest das erste und/oder das zweite Datenelement (15,16) gelöscht werden, wenn sich das zu speichernde Datum nicht durch einen Schreibvorgang jeweiliger Speicherzellen des ersten und/oder des zweiten Datenelements (15,16) erzeugen lässt.

4. Verfahren nach einem der vorherigen Ansprüche, bei dem die logische Verknüpfung durch eine Exklusiv-NICHT-ODER-Verknüpfung (XNOR) gebildet ist.

5. Verfahren nach einem der vorherigen Ansprüche, bei dem das erste und das mit dem ersten Datenelement (15,16) logisch verknüpfte zweite Datenelement (15,16) in dem Datenspeicher hintereinander angeordnet werden bzw. sind.

6. Verfahren nach einem der Ansprüche 1 bis 4, bei dem das erste und das zweite Datenelement (15, 16) Speicherseiten sind, welche logisch miteinander verknüpft werden.

7. Verfahren nach einem der vorherigen Ansprüche, bei dem die Speichereinrichtung (11) einen weiteren Speicher (14) mit weiteren Datenelementen aufweist, welche keine Zuordnung zu anderen Datenelementen aufweisen, wobei erste Informationen und/ oder Variablen in dem ersten und dem mit dem ersten logisch verknüpften zweiten Datenelement (15,16) und zweite Informationen und/ oder Variablen in den weiteren Datenelementen des weiteren Speichers (14) gespeichert werden.

8. Verfahren nach Anspruch 7, bei dem die Auswahl, welche ersten Informationen und/oder Variablen in dem ersten und dem mit dem ersten logisch verknüpften zweiten Datenelement (15,16) gespeichert und/oder aus diesen ausgelesen werden sollen, einem Compiler über ein Schlüsselwort mitgeteilt werden.

9. Verfahren nach einem der vorherigen Ansprüche, bei dem ein Interrupt erzeugt wird, wenn sich das zu speichernde Datum nicht durch einen Schreibvorgang jeweiliger Speicherzellen des ersten und/ oder des zweiten Datenelements (15,16) erzeugen lässt.

10. Speichereinrichtung (11) eines Datenträgers (10), insbesondere eines tragbaren Datenträgers (10) mit
- einem elektronischen Speicher (12) mit zumindest einem ersten und einem zweiten Datenelement (15,16), welche jeweils eine Mehrzahl von binären Speicherzellen umfassen, wobei jede Speicherzelle durch einen Programmiervorgang zwischen einem gelöschten und einem beschriebenen Zustand schaltbar ist und wobei der Speicher (12) bezüglich Schreibvorgängen, bei dem der beschriebene Zustand herstellbar ist, und Löschvorgängen, bei dem der gelöschte Zustand herstellbar ist, asymmetrisch ist,
- einer Logikeinheit (13), welche ausgebildet ist,
- zum Überprüfen, ob das zu speichernde Datum (17) sich aus einer Modifikation jeweiliger Speicherzellen des ersten und/oder des zweiten Datenelements (15,16), die über eine logische Verknüpfung einander zugeordnet sind, unter der Bedingung erzeugen lässt, dass jede zur Erzeugung des Datums (17) zu modifizierende Speicherzelle des ersten und/ oder des zweiten Datenelements (15,16) ausschließlich durch die gleiche Art von Programmiervorgang durchgeführt werden kann, und
- wenn die Bedingung erfüllt ist, zum Erzeugen des Datums (17) durch den Programmiervorgang der jeweiligen Speicherzellen des ersten und/oder zweiten Datenelements (15,16).

11. Speichereinrichtung (11) nach Anspruch 10, bei der das erste und das zweite Datenelement (15,16) ein Byte des Speichers (12) repräsentieren.

12. Speichereinrichtung (11) nach Anspruch 10, bei der das erste und das zweite Datenelement (15,16) eine Speicherseite des Speichers (12) repräsentieren.

13. Speichereinrichtung (11) nach einem der Ansprüche 10 bis 12, bei der der Speicher (12) ein Flash-EEPROM-Speicher (12) zum Speichern von Daten und/ oder Programmen ist.

## Claims

1. A method for storing a datum (17) with a number of bits in a memory device (11) of a data carrier (10), in particular a portable data carrier (10), wherein the memory device (11) has a memory (12) with at least a first and a second data element (15, 16) each of which comprising a number of binary memory cells that corresponds to the number of bits of the datum (17), wherein each memory cell is switchable by a programming operation between a deleted and a written state, and wherein the memory (12) is asymmetric with reference to write operations whereby the written state is obtained, and deletion operations whereby the deleted state is obtained, wherein
- it is checked by a logic unit (13) of the memory device (11) whether the datum to be stored can be generated from a modification of respective memory cells of the first and/ or second data element (15, 16) which are logically linked, under the condition that each memory cell of the first and/ or second data element (15, 16) to be modified in order to generate the datum (17) can be carried out exclusively by the same type of programming operation, and
- if the condition is fulfilled, the datum is generated by the programming operation of the respective memory cells of the first and/ or second data element (15, 16).

2. The method according to claim 1, wherein the asymmetry with reference to write operations and deletion operations comprises that a write operation has a shorter programming time than a deletion operation, or vice versa, and the programming operation is used which has the shorter programming time.

3. The method according to claim 2, wherein at least the first and/ or the second data element (15, 16) are deleted when the datum to be stored cannot be generated by a write operation of respective memory cells of the first and/ or second data element (15, 16).

4. The method according to any of the preceding claims, wherein the logic linkage is formed by an exclusive. NOT-OR operation (XNOR).

5. The method according to any of the preceding claims, wherein the first and the second data element (15, 16) logically linked with the first data element (15, 16) are being or are arranged one behind the other in the data memory.

6. The method according to any of the claims 1 to 4, wherein the first and the second data element (15, 16) are memory pages that are logically linked.

7. The method according to any of the preceding claims, wherein the memory device (11) has a further memory (14) with further data elements having no allocation to other data elements, wherein first information and/ or variables are stored in the first and the second data element (15, 16) logically linked with the first data element, and second information and/ or variables are stored in the further data elements of the further memory (14).

8. The method according to claim 7, wherein the choice which first information and/ or variables are to be stored and/or to be read out from the first and the second data element (15, 16) logically linked with the first data element, is notified to a compiler via a keyword.

9. The method according to any of the preceding claims, wherein an interrupt is generated when the datum to be stored cannot be generated by a write operation of respective memory cells of the first and/ or the second data element (15, 16).

10. A memory device (11) of a data carrier (10), in particular of a portable data carrier (10), having
- an electronic memory (12) with at least a first and a second data element (15, 16) each of which comprising a plurality of binary memory cells, wherein each memory cell is switchable by a programming operation between a deleted and a written state, and wherein the memory (12) is asymmetric with reference to write operations whereby the written state is obtainable and deletion operations whereby the deleted state is obtainable,
- a logic unit (13) configured
- to check whether the datum (17) to be stored can be generated from a modification of respective memory cells of the first and/ or the second data element (15, 16) which are mutually allocated via a logic operation, under the condition that each memory cell of the first and/ or the second data element (15, 16) to be modified in order to generate the datum (17) can be carried out exclusively by the same type of programming operation, and
- if the condition is fulfilled, to generate the datum (17) by the programming operation of the respective memory cells of the first and/ or second data element (15, 16).

11. The memory device (11) according to claim 10, wherein the first and the second data element (15, 16) represent a byte of the memory (12).

12. The memory device (11) according to claim 10, wherein the first and the second data element (15, 16) represent a memory page of the memory (12).

13. The memory device (11) according to any of the claims 10 to 12, wherein the memory (12) is a Flash-EEPROM memory (12) for storing data and/ or programs.

## Revendications

1. Procédé de mémorisation d'une date (17) ayant un nombre de bits dans un dispositif de mémorisation (11) d'un support de données (10), notamment d'un support de données (10) portable, le dispositif de mémorisation (11) comportant une mémoire (12) ayant au moins un premier et un deuxième élément de données (15, 16) qui comprennent respectivement un nombre de cellules mémoire binaires qui correspond au nombre de bits de la date (17), chaque cellule mémoire étant, par une opération de programmation, commutable entre un état effacé et un état en écriture, et la mémoire (12) étant asymétrique quant à des opérations d'écriture dans lesquelles l'état en écriture est engendré et à des opérations d'effaçage dans lesquelles l'état effacé est engendré, dans lequel
• par une unité logique (13) du dispositif de mémorisation (11), il est vérifié si l'on peut, à partir d'une modification de cellules mémoire respectives du premier et/ou du deuxième élément de données (15, 16) qui sont liés logiquement, générer la date à mémoriser sous la condition que chaque cellule mémoire à modifier du premier et/ou du deuxième élément de données (15, 16) pour la génération de la date (17) ne peut être exclusivement effectuée que par le même type d'opération de programmation, et
• si la condition est remplie, la date est générée par l'opération de programmation des cellules mémoire respectives du premier et/ou deuxième élément de données (15, 16).

2. Procédé selon la revendication 1, dans lequel l'asymétrie quant à des opérations d'écriture et des opérations d'effaçage inclut qu'une opération d'écriture a un temps de programmation plus court que l'opération d'effaçage, ou inversement, et que l'opération de programmation utilisée est celle qui a le temps de programmation le plus court.

3. Procédé selon la revendication 2, dans lequel au moins le premier et/ou le deuxième élément de données (15, 16) sont effacés quand la date à mémoriser ne peut pas être générée par l'opération d'écriture de cellules mémoire respectives du premier et/ou deuxième élément de données (15, 16).

4. Procédé selon une des revendications précédentes, dans lequel la liaison logique est constituée par une liaison NON-OU-exclusif (XNOR).

5. Procédé selon une des revendications précédentes, dans lequel le premier élément de données ainsi que le deuxième élément de données (15, 16) lié logiquement au premier (15, 16) sont agencés l'un derrière l'autre dans la mémoire de données.

6. Procédé selon une des revendications de 1 à 4, dans lequel le premier et le deuxième élément de données (15, 16) sont des pages de mémoire qui sont liées logiquement entre elles.

7. Procédé selon une des revendications précédentes, dans lequel le dispositif de mémorisation (11) comporte une mémoire supplémentaire (14) ayant des éléments de données supplémentaires qui ne comportent pas d'affectation à d'autres éléments de données, des premières informations et/ou des variables étant mémorisées dans le premier élément de données ainsi que dans le deuxième élément de données (15, 16) lié logiquement au premier, et des deuxièmes informations et/ou des variables étant mémorisées dans les éléments de données supplémentaires de la mémoire supplémentaire (14).

8. Procédé selon la revendication 7, dans lequel le choix des premières informations et/ou variables devant être mémorisées dans le premier élément de données ainsi que dans le deuxième élément de données (15, 16) lié logiquement au premier, ou bien devant être lues à partir de ces derniers, est communiqué à un compilateur par l'intermédiaire d'un mot-clé.

9. Procédé selon une des revendications précédentes, dans lequel une interruption est générée quand la date à mémoriser ne peut pas être générée par une opération d'écriture de cellules mémoire respectives du premier et/ou du deuxième élément de données (15, 16).

10. Dispositif de mémorisation (11) d'un support de données (10), notamment d'un support de données (10) portable, ayant
• une mémoire électronique (12) ayant au moins un premier et un deuxième élément de données (15, 16) qui comprennent respectivement une pluralité de cellules mémoire binaires, chaque cellule mémoire étant, par une opération de programmation, commutable entre un état effacé et un état en écriture, et la mémoire (12) étant asymétrique quant à des opérations d'écriture dans lesquelles l'état en écriture peut être engendré et à des opérations d'effaçage dans lesquelles l'état effacé peut être engendré,
• une unité logique (13) qui est conçue
• pour vérifier si la date (17) à mémoriser peut, à partir d'une modification de cellules mémoire respectives du premier et/ou du deuxième élément de données (15, 16) qui sont, par une liaison logique, mutuellement affectés, être générée sous la condition que chaque cellule mémoire à modifier du premier et/ou du deuxième élément de données (15, 16) pour la génération de la date (17) ne peut être exclusivement effectuée que par le même type d'opération de programmation, et
• si la condition est remplie, pour générer la date (17) par l'opération de programmation des cellules mémoire respectives du premier et/ou deuxième élément de données (15, 16).

11. Dispositif de mémorisation (11) selon la revendication 10, dans lequel le premier et le deuxième élément de données (15, 16) représentent un octet de la mémoire (12).

12. Dispositif de mémorisation (11) selon la revendication 10, dans lequel le premier et le deuxième élément de données (15, 16) représentent une page de mémoire de la mémoire (12).

13. Dispositif de mémorisation (11) selon une des revendications de 10 à 12, dans lequel la mémoire (12) est une mémoire Flash-EEPROM (12) pour la mémorisation de données et/ou de programmes.
